# EUROPEAN PATENT APPLICATION

(11) **EP 4 648 096 A1**
(43) Date of publication of application: **12.11.2025**
(21) Application number: 24174345.9
(22) Date of filing: 06.05.2024
(51) Int. Cl.: H01L 23/31, H01L 23/498, H01L 25/07

(54) **POWER DEVICE, SYSTEM, AND METHOD FOR PRODUCING A POWER DEVICE**

(71) Applicant: Hitachi Energy Ltd, 8050 Zürich (CH)
(72) Inventor: SANTOLARIA, Lluis, 4600 Olten (CH); TRUESSEL, Dominik, 5620 Bremgarten (CH); MALEKI, Milad, 5417 Untersiggenthal (CH)
(74) Representative: Epping - Hermann - Fischer

(57) **Abstract**

A power device (1) is specified, comprising
- at least one power semiconductor chip arranged on a mounting portion (2),
- a package body (3), for the at least one power semiconductor chip, with at least one recess (4) exposing at least one partial region of a connection region (5),
- a terminal block (6) comprising
- a molded block (7) with at least one further recess (8), and
- at least one first terminal (9) arranged in the at least one further recess (8), wherein

- the terminal block (6) is arranged on the package body (3),
- the at least one first terminal (9) is further arranged in the at least one recess (4) of the package body (3),
- the at least one first terminal (9) is electrically connected to the at least one partial region of the connection region (5).

Furthermore, a system and a method for producing a power device are specified.

## Description

The present disclosure relates to a power device, a system, and a method for producing a power device.

Typically, integration of vertically arranged terminals in a transfer molded power device is a complex challenge. Also an implementation of hollow sleeves as holders for pin terminals to be embedded in a typical molded package body makes a transfer molding process comparatively complicated.

Embodiments of the disclosure relate to a power device with vertically arranged terminals which is comparatively easy to handle. Further embodiments relate to a system and a method for producing such a power device.

This is achieved by the subject-matter of the independent claims. Further embodiments are evident from the dependent claims and the following description.

A power device is described. The term "power" here and in the following, for example, refers to power semiconductor devices and/or power semiconductor chips adapted for processing voltages and currents of more than 100 V and/or more than 10 A, exemplarily voltages of up to 10 kV and electrical currents of up to 10 kA.

According to an embodiment, the power device comprises at least one power semiconductor chip arranged on a mounting portion. The power semiconductor chip comprises, for example, a semiconductor material such as at least one of silicon (Si), silicon carbide (SiC), and gallium nitride (GaN). The power semiconductor chip is, for example, a power diode and/or a power metal insulating semiconductor field-effect transistor, power MISFET for short. The term MISFET shall also include MOSFETs, which have an oxide as an insulating material at a gate. The power semiconductor chip may also be an insulated-gate bipolar transistor, IGBT.

The mounting portion is, for example, part of a carrier, a lead frame, a baseplate, an insulated metal substrate or a substrate of the power device. The mounting portion has, for example, a main extension plane. The main extension plane extends particularly in lateral directions. A vertical direction is oriented perpendicular to the lateral directions. Exemplarily, the power semiconductor chip has a main extension plane parallel to the lateral directions.

According to the embodiment, the power semiconductor device comprises a package body for the at least one power semiconductor chip. The package body has at least one recess exposing at least one partial region of a connection region. The power semiconductor chip is, for example, embedded in the package body. "Embedded" means here and in the following that the package body is arranged at least partly on at least one outer surface of the power semiconductor chip. For example, the power semiconductor chip is completely surrounded, e.g. three-dimensionally, by the package body and the mounting portion.

Exemplarily, the package body comprises or consists of an electrically insulating material. A length and/or a width in lateral directions of the package body is, for example, at least 10 mm or at least 20 mm and/or at most 100 mm. A height in vertical direction of the package body is, for example, at least 2 mm.

Exemplarily, the connection region comprises an electrically conductive material and exemplarily comprises a metal or a metallic alloy. The connection region is, for example, electrically connected with a contact portion of the power semiconductor device. The connection region can have an optional conductive coating such as nickel, silver, and/or gold layer.

For example, the recess completely penetrates the package body in a vertical direction. "Exposing" means here and in the following that at least the partial region of the connection region or the whole area of the connection region is not covered by the package body. In particular, the partial region of the connection region and the recess completely overlap in lateral directions in a top view.

Exemplarily, the connection region comprises at least one of a metal pattern of a substrate, a coated region with a coating, a diepad and/or a terminal of a leadframe.

For example, the package body comprises a plurality of recesses exposing a plurality of connection regions. Exemplarily, a number of recesses and a number of connection regions are equal to one another. Each of the recesses exposes at least one of the connection regions, in particular exactly one of the connection regions, particularly a part thereof.

At least one or at least some of the connection regions can be part of the mounting portion. Alternatively or additionally, at least one or at least some of the connection regions can be part of the semiconductor chip.

According to the embodiment, the power device comprises a terminal block.

According to the embodiment of the power device, the terminal block comprises a molded block with at least one further recess. Exemplarily, the molded block comprises or consists of an electrically insulating material like thermosetting or thermoplastic resin. For example, the further recess completely penetrates the molded block in a vertical direction.

For example, the molded block comprises a plurality of further recesses. Exemplarily, the number of recesses and a number of further recesses are equal to one another.

According to the embodiment of the power device, the terminal block comprises at least one first terminal arranged in the at least one further recess. Exemplarily, the first terminal has a main extension direction being parallel to the vertical direction. The first terminal comprises or consists of an electrically conductive material like copper, aluminum, and/or corresponding alloy.

Exemplarily, the terminal block comprises a plurality of first terminals. For example, the number of further recesses and the number of first terminals are equal to one another. In particular, each one of the first terminals is arranged in one of the further recesses.

According to the embodiment of the power device, the terminal block is arranged on the package body. For example, the molded block has a top surface and a bottom surface opposite the top surfaces. The top surface and the bottom surface are connected with a first side surface and a second side surface as well as a first face surface and a second face surface. In particular, the bottom surface of the molded block is arranged on the package body. Exemplarily, the package body has a cut-out, in particular a cut-out in the top surface. The terminal block is, for example, arranged within the cut-out .

Exemplarily, the terminal block, particularly the molded block, has main extension plane parallel to the lateral directions. Exemplarily, the terminal block, particularly the molded block, does not protrude beyond the package body in lateral directions. Alternatively, the molded block protrudes beyond the package body in lateral directions, at least at one side surface of the package body.

According to the embodiment of the power device, the at least one first terminal is further arranged in the at least one recess of the package body.

According to the embodiment of the power device, the at least one first terminal is electrically connected to the at least one partial region of the connection region. For example, the first terminal is in direct contact with the connection region.

Exemplarily, an electrical signal can be transmitted between the first terminal and the power semiconductor chip via the connection region. The first terminal is exemplarily configured to be a control terminal of the power semiconductor chip. Alternatively or additionally, the first terminal is exemplarily configured as a power terminal, at least for a power semiconductor chip. In this case, the first terminal is connected with a common connection region, in particular with a common part of the connection region using one common or multiple individual further recesses.

If the first terminal is exemplarily configured as power terminal, the terminal block comprises a plurality of first terminals, wherein at least some of the first terminals are connected in parallel, and wherein the at least some of the first terminals are configured as the power terminal.

Advantageously, the use of the terminal block to be mounted on the package body with the first terminal leads to a significant process simplification, including easier transfer molding process, and reduces equipment expenditure e.g. for pin insertion. By using the molded block, an improved alignment tolerance between the first terminals themselves and between first terminals and the recess due to a high precision process like injection molding or transfer molding can advantageously be guaranteed.

In particular, a generally improved alignment tolerance towards a customer can be achieved as well as an improved design flexibility, wherein a design of the first terminal structure, e.g. a choice of a first terminal type, can be adjusted according to a customer's request. Additionally, the design of the terminal block itself can be adjusted according to customer application, e.g. for a single package or for a sixpack setup, where there is a common terminal block for three single packages,.

Further, as the terminal block can be mounted on the customer's end advantageously improves process flexibility. With the first terminal arranged in the molded block, a comparatively increased stiffness of the first terminal is achieved, which advantageously leads to a less risky insertion process, e.g. of a press-fit section into an opening of a printed circuit board, particularly a control board.

The proposed power device comprises the recesses in the package body, such that portions of the connection regions are exposed from the package body, where the first terminals can get in contact with the connection regions or at least in electrical connection. In particular, the terminal block can be a control terminal structure, where one or more first terminals are embedded in the molded block. In particular, the first terminal is a control terminal for the power semiconductor chip. Alternatively or additionally, the first terminal can also be used as a power terminal.

According to a further embodiment of the power device, the power device comprises at least one second terminal electrically connected to the at least one power semiconductor chip. Exemplarily, the second terminal is embedded at least partially in the package body. An end region of the second terminal protrudes, for example, initially beyond the package body in lateral directions. The end region is, for example, configured to be contacted externally. The second terminal is formed, for example, as a power terminal.

According to a further embodiment of the power device, the at least one first terminal has a main extension direction being oblique to a main extension plane of the at least one second terminal. Exemplarily, the main extension direction of the first terminal is approximately perpendicular to the main extension plane of the second terminal. "Approximately perpendicular" means here that the first terminal has an angle of 90° plus/minus at most 5°, in particular approximately at most 1° to the main extension plane of the second terminal.

According to a further embodiment of the power device, the mounting portion comprises a top metallization layer, an insulating layer and a bottom metallization layer. The top metallization is in particular a circuit metallization. The top metallization layer can comprise a plurality of parts. At least some of the parts of the top metallization layer are spaced apart from one another in lateral directions. At least some of the parts spaced apart from one another have no direct electrical connection. Exemplarily, the power semiconductor chip is arranged on a first part of the top metallization layer. The top and/or bottom metallization layer can comprise a coating e.g. of a noble metal like nickel, gold or silver.

Exemplarily, the mounting portion comprises a diepad of terminals in a leadframe-based power package.

According to a further embodiment of the power device, a partial region of the top metallization layer is exposed by the at least one recess of the package body for forming the partial region of the connection region. In particular, the partial region of the top metallization layer is formed by a second part of the top metallization layer spaced apart from the first part. Exemplarily, the complete second part or only a portion of a second part is exposed.

According to a further embodiment of the power device, the at least one first terminal has the form of a pin. Exemplarily, the first terminal has a cylindrical shape, a conical shape or a tapered shape. Exemplarily, the first terminal has a diameter in lateral directions of at least 0.1 mm to at most 5 mm.

The first terminal exemplarily comprises or consists of an electrically conductive metal such as copper, aluminum, brass, nickel, silver and/or gold, in particular alloys thereof. Exemplarily, the first terminal can have a coating comprising or consisting of a further electrically conductive metal covering the electrically conductive metal. Exemplarily the coating comprises or consists of nickel, silver and/or gold.

According to a further embodiment of the power device, the at least one first terminal has a top part facing away from the mounting portion or exemplarily facing away from the package body or the recess, an intermediate part arranged in the further recess, and a bottom part arranged in the recess. In particular, the top part and the bottom part protrude beyond the molded block in vertical directions, whereas the intermediate part is arranged in the further recess. The bottom part is configured to be electrically connected to the connection region, and the top part is configured to be electrically contactable externally.

According to a further embodiment of the power device, the at least one first terminal comprises at least one pin connector and/or at least one press fit connector for external connection.

According to a further embodiment of the power device, the intermediate part is structured. Exemplarily, the intermediate part can have a width which is smaller than a width of a top part and/or a bottom part of the at least one first terminal. For example, the intermediate part can have a cut-out.

The intermediate part being structured can comprise a press-fit connector, a glue connection, an elastic portion, or a spring portion and/or a bedstop. The structure is in particular configured to prevent movement or displacement of the first terminal.

Advantageously, a fixation of the first terminal with the intermediate part being structured in the further recess is particularly strong and reliable.

According to a further embodiment of the power device, the bottom part is structured. Exemplarily, the bottom part comprises regions with different widths. For example, the bottom part being structured can comprise the same elements as the intermediate part being structured described herein above.

According to a further embodiment of the power device, the intermediate part has a width which is larger than a width of the top part and/or the bottom part of the at least one first terminal. Due to the comparatively large width, a surface area connected to a side surface delimiting the further recess is increased and thus advantageously improves the mechanical fixation of the first terminal in the further recess.

According to a further embodiment of the power device, the at least one first terminal is connected to the connection region by a connection element. The connection element comprises or consists of an electrically conductive material configured to provide an electrically conductive connection between the first terminal and the connection region.

According to a further embodiment of the power device, the connection element is at least one of an elastic connection, a glue, and a solder material. In particular, the glue is an electrically conductive glue. Exemplarily, the elastic connection is a spring. If the connection element is an elastic connection, the connection element can be an integral part of the first terminal, in particular of the bottom part.

Alternatively, the first terminal is connected to the connection region via welding such as a resistive welding or a laser welding.

The glue, the solder material is exemplarily arranged within the recess. The glue, the welding material or the solder material is in particular directly arranged on the connection region. The glue, or the solder material is arranged in the recess up to a predetermined height in a vertical direction. Exemplarily, the predetermined height is equal to or smaller than a height of the recess in a vertical direction.

The connection element is configured to provide an electrical and/or mechanical connection between the first terminal and the connection region, which is exemplarily realized by a conductive glue, a solder material such as a low temperature solder, a snap-fit connection to e.g. a previously existing part bonded to the connection region, or any other applicable joining method. Exemplarily, a spring connection or other kinds of flexible connection elements between the first terminal and the connection region are conceivable.

According to a further embodiment of the power device, the package body and/or the molded block comprises a resin. Exemplarily, the package body comprises or consists of a thermoplastic resin or a thermosetting resin.

According to a further embodiment of the power device, the molded block comprises at least one filler material. In particular, the filler material is incorporated in the resin. The filler material comprises or consists of particles and/or fibers, e.g. comprising or consisting of silica.

Advantageously, the filler material is mainly used for mechanical enforcement of the molded block.

According to a further embodiment of the power device, the at least one first terminal is in direct contact with the molded block.

According to a further embodiment of the power device, the molded block comprises at least one structural element on a top surface facing away from the package body. The structural element of the top surface of the molded block is, for example, at least one elevation or at least one further cut-out, both extending in a vertical direction, having a width in lateral directions. Exemplarily, the structural element of the top surface of the molded block surrounds the first terminal in lateral directions completely or partially. In particular, the structural element is adjacent to the first terminal.

The structural elements can be advantageously used for an improved creepage, to overcome manufacturing limitations and/or mechanical stability. With such a terminal block, all creepage distances can be met.

If the terminal block comprises the plurality of first terminals, the molded block comprises a plurality of structural elements on the top surface of the molded block, wherein at least one structural element is arranged between two directly neighboring first terminals, in particular between the top parts thereof.

According to a further embodiment of the power device, the molded block comprises at least one structural element on a bottom surface facing the package body. The structural element of the bottom surface of the molded block is, for example, at least one elevation or at least one further cut-out both extending in a vertical direction, having a width in lateral directions. Exemplarily, the structural element of the bottom surface surrounds the first terminal in lateral directions completely or partially. The structural element can be adjacent to first terminal, particularly if the structural element is used for an alignment.

If the terminal block comprises the plurality of first terminals, the molded block comprises a plurality of structural elements on the bottom surface of the molded block, wherein at least one structural element is arranged between two directly neighboring first terminals, in particular between the bottom parts thereof.

According to a further embodiment of the power device, the package body comprises at least one structural element on a top surface facing the molded block. In particular, the structural element is formed on a top surface of the cut-out of the package body facing the molded block. The structural element of the top surface of the package body is, for example, at least one elevation or at least one further cut-out, both extending in a vertical direction, having a width in lateral directions. Exemplarily, the structural element of the top surface of the package body surrounds the first terminal in lateral directions completely or partially.

If the structural element of the bottom surface of the molded block is an elevation, the top surface of the package body is a further cut-out, and vice versa.

According to a further embodiment of the power device, the at least one structural element on the top surface of the package body and the at least one structural element on the bottom surface of the molded block interlock. Exemplarily, the bottom surface of the molded block is an elevation and the top surface of the package body is a further cut-out, wherein the elevation fits in the further cut-out. Alternatively, the bottom surface of the molded block is a further cut-out and the top surface of the package body is an elevation, wherein the elevation fits in the further cut-out.

A further embodiment relates to a system, in particular comprising a power device as described herein above. Therefore, the features as described in connection with the system are also applicable to the power device and vice versa.

According to the embodiment, the system comprises a power device described herein above.

According to the embodiment, the system comprises a cooler and/or heat sink on which the power device is arranged. The heat sink comprises, for example, fins and/or other structures configured to increase a surface area being in contact with a coolant and particularly increase a cooling efficiency. The heat sink is exemplarily configured to absorb and dissipate heat from the power semiconductor chip. The cooler comprises, for example, a channel through which a cooling fluid can flow. Exemplarily, the heat sink is arranged on the cooler being in contact with the coolant. In particular, the cooler is exemplarily configured to absorb and dissipate heat from the power semiconductor chip and/or the heat sink.

Exemplarily, the cooler has an extrudate extending in a vertical direction up to the molded block. Alternatively or additionally, the molded block has an extrudate extending in a vertical direction down to the cooler.

According to the embodiment of the system, the terminal block is connected to the package body by a fixing element and/or the terminal block is connected to the cooler by a further fixing element. Exemplarily, at least one of the terminal block, the package body and the cooler comprises at least one fixing element. The fixing element can be e.g. at least one of a glue, a rivet, a snap-fit connection, a clamp, a screw.

For example, the terminal block and/or the package body can comprise the fixing element, respectively, wherein the respective fixing elements are configured to fix the terminal block to the package body. Exemplarily, the terminal block and/or the cooler can comprise the further fixing element, respectively, wherein the respective further fixing elements are configured to fix the terminal block to the cooler. Exemplarily, the package body and/or the cooler can comprise an additional fixing element, respectively, wherein the respective additional fixing elements are configured to fix the package body to the cooler.

According to the embodiment of the system, the terminal block, the package body and/or the cooler each comprise at least one alignment structure, respectively. The alignment structure can be at least one of an opening and a protruding part. Exemplarily, alignment structures are fitting to corresponding alignment structures of a connection partner.

Exemplarily, the cooler comprises at least one protruding part and the terminal block and/or the package body each comprise at least one opening. The openings and the protruding part are overlapping in lateral directions in a top view. The openings are configured to receive the protruding part. The protruding part is a pin, for example.

Exemplarily, the package body comprises at least one protruding part and the terminal block comprises at least one opening.

The protruding part can be also used e.g. for an improved glue connection. The alignment structure advantageously provides a proper positioning with respect to the package body. Therefore, an alignment of the cooler, the terminal block and/or the package body with respect to one another is advantageously achieved.

According to a further embodiment, the system comprises a plurality of power devices. The power devices are exemplarily arranged on the cooler and/or the heat sink, wherein the power devices are spaced apart from one another in lateral directions. In particular, the power devices are arranged as an array or in a row.

According to a further embodiment of the system, each of at least some of the power devices comprises a single terminal block. In particular, all power devices each comprise one of the single terminal blocks. This means that each power device is assigned to one terminal block. A number of power devices particularly equals a number of terminal blocks.

According to a further embodiment of the system, at least some of the power devices comprise a common terminal block. In particular, all power devices comprise the common terminal block being the terminal block. This means that the terminal block extends over all power devices in a lateral direction.

A further embodiment relates to a method for producing a power device, in particular a power device as described herein above. Therefore, the features as described in connection with the method are also applicable to the power device and vice versa.

According to the embodiment of the method, at least one power semiconductor chip arranged on a mounting portion is provided.

According to the embodiment of the method, a package body, for the at least one power semiconductor chip, with at least one recess in the package body for exposing at least one partial region of a connection region is provided. The package body is produced by a transfer molding process, for example.

According to the embodiment of the method, a molded block with at least one further recess is provided for forming at least one terminal block. The molded block is, for example, produced by an injection molding process or another molding process, such as a transfer molding process.

According to the embodiment of the method, the at least one terminal block is arranged on the package body such that at least one first terminal is arranged in the at least one further recess of the molded body, and the at least one first terminal is further arranged in the at least one recess of the package body, and the at least one first terminal is connected to the at least one partial region of the connection region.

According to a further embodiment of the method, the at least one first terminal is provided in the molded block before arranging the at least one terminal block on the package body. Exemplarily, the first terminal is embedded in the molded block during the production of the molded block, in particular such that the first terminal is an integral part of the terminal block.

According to a further embodiment of the method, the at least one first terminal is provided in the molded block after arranging the at least one terminal block on the package body.

This means that the insertion of the first terminal in the molded block can be done after the production of the molded block, but also after the production of the molded block and in particular after a mounting of the molded block on the package body.

Exemplarily, the first terminal is fixed in the further recess by at least one of a press-fit connector for fixation of the first terminal in the further recess, a glue connection between the first terminal and the further recess, and a spring portion, an elastic portion and a bedstop located on a bottom surface of the molded block.

The use of a terminal block with the integrated first terminal makes the assembly of the power device advantageously more flexible. On the one hand, the terminal block can be mounted directly after the assembly of the power semiconductor chip and the package body. On the other hand, it is possible to mount the terminal block after joining of one or more power semiconductor chips with respective package bodies to a cooler. Additionally, a design of the first terminal can be adjusted according to a customer's request, e.g. by a corresponding choice of the terminal type. Even the design of the whole terminal block can be adjusted according to customer requirements.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.

Figure 1 shows a schematic view of a power device according to an exemplary embodiment.

Figures 2, 3 and 4 each show a schematic view of a first terminal of a power device according to an exemplary embodiment.

Figures 5, 6 and 7 schematically show method stages of the method for producing a power device according to an exemplary embodiment.

Figures 8 and 9 each show a schematic view of a system comprising a power device according to an exemplary embodiment.

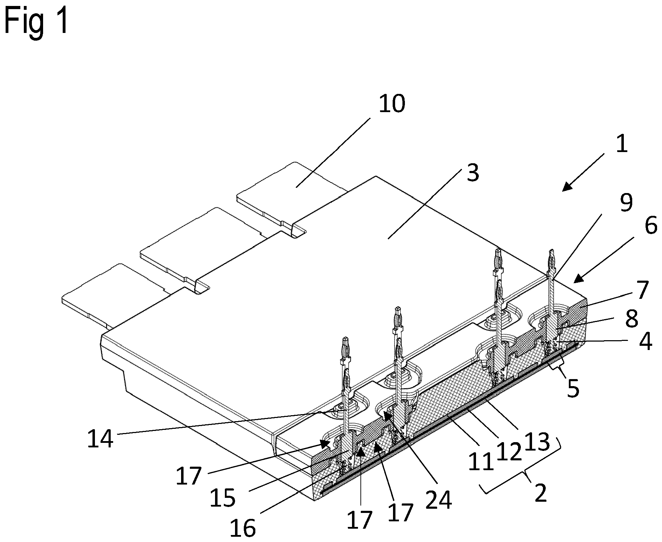

The power device 1 according to the exemplary embodiment of Figure 1 comprises at least one power semiconductor chip not shown in Figure 1, which is arranged on a mounting portion 2. The mounting portion 2 comprises a top metallization layer 11, an insulating layer 12 and a bottom metallization layer 13. The power device 1 further comprises a package body 3 with recesses 4 each exposing a partial region of a connection region 5. In particular, a partial region of the top metallization layer 11 is exposed by recesses 4 of the package body 3 for forming the partial region of the connection region 5. The recesses 4 each extend in a vertical direction, perpendicular to lateral directions.

The power semiconductor chip is embedded in the package body 3, particularly such that the mounting portion 2 and the package body 3 completely, e.g. three-dimensionally, surround the power semiconductor chip.

The power device 1 comprises second terminals 10, being electrically connected to the power semiconductor chip. The second terminals 10 have a main extension plane being parallel to a main extension plane of the mounting portion 2 and/or the power semiconductor chip. The lateral directions are oriented along the main extension planes. The second terminals 10 are partially embedded in the package body 3. End regions of the second terminals 10 each protrude in lateral directions beyond the package body 3.

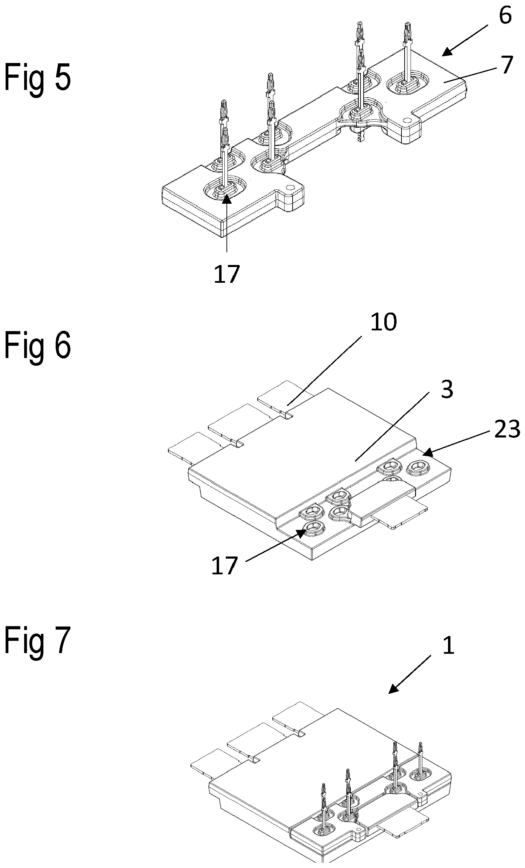

The package body 3 has a cut-out, wherein the cut-out 23, as shown in connection to Figure 6, comprises a top surface. In particular, the package body 3 comprises structural elements 17 on the top surface of the cut-out 23. The structural elements 17 comprise elevations, wherein two neighboring elevations form a further cut-out 24.

The power device 1 comprises a terminal block 6, wherein the terminal block 6 comprises a molded block 7 with further recesses 8, and first terminals 9. Each terminal is arranged in one of the further recesses 8. The terminal block 6 is arranged on the package body 3, in particular in the cut-out 23, such that each of the first terminals 9 is further arranged in one of the recesses 4 of the package body 3.

Each of the first terminals 9 is electrically connected to each partial region of each of the connection regions 5.

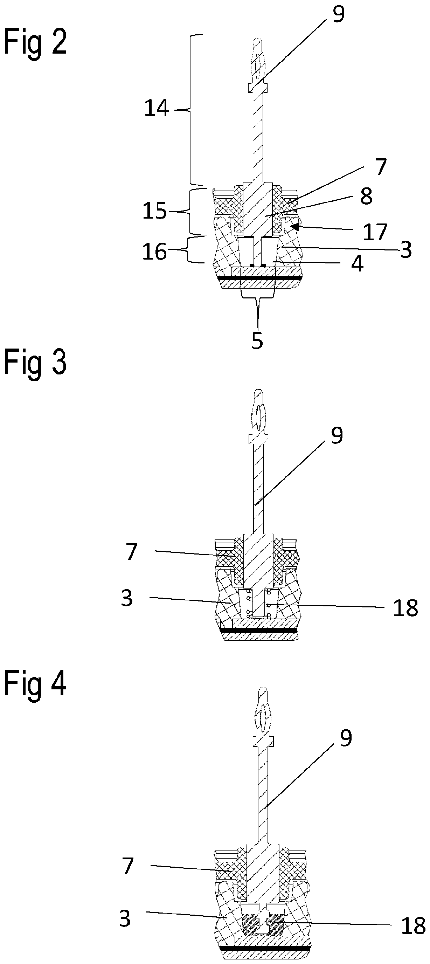

The first terminals 9 each have a main extension direction being oblique, in particular perpendicular, to the main extension plane of the second terminals 10. This means that the first terminals 9 each extend in a vertical direction. A top part 14 of each of the first terminals 9 faces away from the mounting portion 2, particularly protruding beyond the molded block 7 in a vertical direction, being illustrated in Figures 2, 3 and 4 in greater detail. In particular, each of the top parts is configured to be connected externally. An intermediate part 15 of each of the first terminals 9 is arranged in the further recess 8. In particular, each of the intermediate parts is configured to provide a stable mechanical connection between the first terminals 9 and the molded block 7. A bottom part 16 of each of the first terminals 9 face the mounting portion 2, particularly protruding beyond the molded block 7 in a vertical direction. In particular, each of the bottom parts is configured to be electrically connected to the respective connection region 5.

The molded block 7 comprises structural elements 17 on a top surface facing away from the package body 3. Further, the molded block 7 comprises structural elements 17 on a bottom surface facing the package body 3. The structural elements 17 on the bottom surface comprise elevations, wherein one of the elevations fits in the further cut-out of the package body 3. This means that at least some structural elements 17 on the top surface of the package body 3 and at least some structural elements 17 on the bottom surface of the molded block 7 interlock. Exemplarily, the structural elements 17 on the bottom surface of the molded block 7 can be arranged at least partly in the recess 4 of the package body 3.

The first terminal 9 according to the exemplary embodiments of Figures 2, 3 and 4 comprises, as described in connection with Figure 1, a top part 14, an intermediate part 15, and a bottom part 16. The bottom part 16 is connected to the connection region 5 by a connection element 18. The connection element 18 according to Figure 4 is an electrically conductive glue, which is provided in the recess 4. The connection element 18 according to Figure 3 is an elastic connection such as a spring, which is provided in the recess 4. The first terminal 9 according to Figure 2 is directly connected to the top metallization layer 11 in the connection region 5.

The bottom part 16 in Figure 4 of the first terminal 9 is structured with broadened parts. Further, the intermediate part 15 has a width which is larger than a width of the top part 14 or the bottom part.

The broadened parts at the bottom part 16 are exemplarily used to increase an interface between the glue and the first terminal, therefore enhancing conductive gluing connection.

The intermediate part 15 being broadened is in particular important to improve manufacturability, handling, mechanical stability of pin and adhesion between pin and injected plastic around it.

In connection with the method stage according to Figure 5, a molded block 7 with further recesses 8 is provided. Further first terminals 9 are arranged in the further recesses 8, particularly during or after the production of the molded block 7, for forming a terminal block 6.

In connection with the method stage according to Figure 6, at least one power semiconductor chip arranged on a mounting portion 2 and a package body 3 are provided. The package body 3 has the recesses 4 as described in connection with Figure 1.

In connection with the method stage according to Figure 7, the terminal block 6 is arranged on the package body 3 for producing a power device 1 according to the exemplary embodiment of Figure 1, such that structural elements of the molded block and the package body are fitting to each other, and that the bottom parts of first terminals are inserted into the recesses.

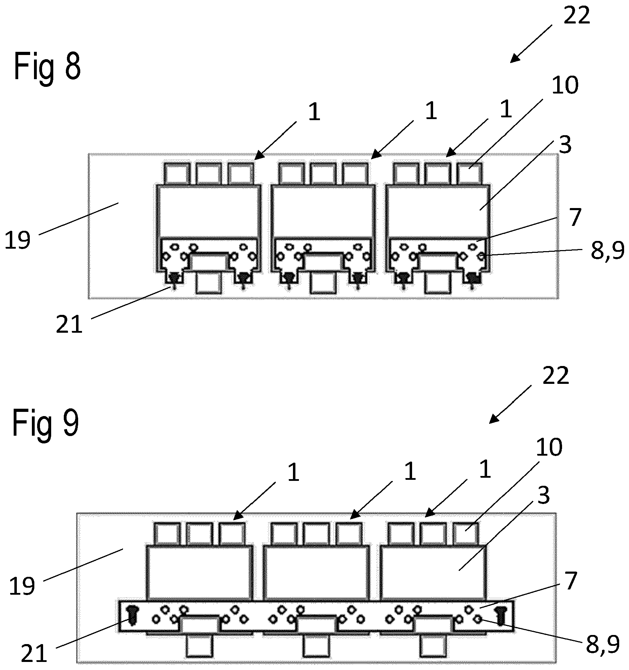

The system 22 according to the exemplary embodiments of Figures 8 and 9 comprises three of the power devices 1 described in Figure 1. The power devices 1 are arranged on a cooler 19, e.g. by further fixing elements 21.

In Figure 8, each power device 1 comprising a single package body 3 is provided with a single terminal block 6. Further, each terminal block 6 according to Figure 9 is connected to the cooler 19 by further fixing elements 21, each being formed of a screw.

For fixing purposes, dimensions in lateral directions of the terminal block may exceed a perimeter of the package body in particular for a fixation to the cooler.

In Figure 9, a single common terminal block 6 is provided to all the three power devices 1 comprising a single package body 3. Further, the terminal block 6 according to Figure 9 is connected to the cooler 19 by further fixing elements 21, each being formed e.g. of a screw or a clamp, exemplarily, if the cooler provides corresponding fixation structures like screw holes or structures for clamping.

The exemplary embodiments, in particular features of the exemplary embodiments, of the Figures can be combined with one another.

### Reference Signs

- 1: power device
- 2: mounting portion
- 3: package body
- 4: recess
- 5: connection region
- 6: terminal block
- 7: molded block
- 8: further recess
- 9: first terminal
- 10: second terminal
- 11: top metallization layer
- 12: insulating layer
- 13: bottom metallization layer
- 14: top part
- 15: intermediate part
- 16: bottom part
- 17: structural element
- 18: connection element
- 19: cooler
- 20: fixing element
- 21: further fixing element
- 22: system
- 23: cut-out
- 24: further cut-out

## Claims

1. Power device (1) comprising
- at least one power semiconductor chip arranged on a mounting portion (2),
- a package body (3), for the at least one power semiconductor chip, with at least one recess (4) exposing at least one partial region of a connection region (5),
- a terminal block (6) comprising
- a molded block (7) with at least one further recess (8), and
- at least one first terminal (9) arranged in the at least one further recess (8), wherein
- the terminal block (6) is arranged on the package body (3),
- the at least one first terminal (9) is further arranged in the at least one recess (4) of the package body (3),
- the at least one first terminal (9) is electrically connected to the at least one partial region of the connection region (5).

2. Power device (1) according to claim 1, wherein
- the power device (1) comprises at least one second terminal (10) electrically connected to the at least one power semiconductor chip, and
- the at least one first terminal (9) has a main extension direction being oblique to a main extension plane of the at least one second terminal (10).

3. Power device (1) according to one of claims 1 and 2, wherein
- the mounting portion (2) comprises a top metallization layer (11), an insulating layer (12) and a bottom metallization layer (13), and
- a partial region of the top metallization layer (11) is exposed by the at least one recess (4) of the package body (3) for forming the partial region of the connection region (5) .

4. Power device (1) according to one of claims 1 to 3, wherein
- the at least one first terminal (9) has the form of a pin, and/or
- the at least one first terminal (9) comprises at least one pin connector and/or at least one press fit connector.

5. Power device (1) according to one of claims 1 to 4, wherein
- the at least one first terminal (9) has a top part (14) facing away from the mounting portion (2), an intermediate part (15) arranged in the further recess (8), and a bottom part (16) arranged in the recess (4).

6. Power device (1) according to claim 5, wherein
- the intermediate part (15) is structured,
- the bottom part (16) is structured, and/or
- the intermediate part (15) has a width which is larger than a width of the top part (14) and/or the bottom part (16) of the at least one first terminal (9).

7. Power device (1) according to one of claims 1 to 6, wherein
- the at least one first terminal (9) is connected to the connection region (5) by a connection element (18), and
- the connection element (18) is at least one of an elastic connection, a glue, and a solder material.

8. Power device (1) according to one of claims 1 to 7, wherein
- the package body (3) and/or the molded block (7) comprise(s) a resin, and/or
- the molded block (7) comprises at least one filler material.

9. Power device (1) according to one of claims 1 to 8, wherein
- the at least one first terminal (9) is in direct contact with the molded block (7).

10. Power device (1) according to one of claims 1 to 9, wherein
- the molded block (7) comprises at least one structural element (17) on a top surface facing away from the package body (3),
- the molded block (7) comprises at least one structural element (17) on a bottom surface facing the package body (3), and/or
- the package body (3) comprises at least one structural element (17) on a top surface facing the molded block (7).

11. Power device (1) according to claim 10, wherein
- the at least one structural element (17) on the top surface of the package body (3) and the at least one structural element (17) on the bottom surface of the molded block (7) interlock.

12. System (22) comprising
- a power device (1) according to one of claims 1 to 11, and
- a cooler (19) and/or heat sink on which the power device (1) is arranged, wherein
- the terminal block (6) is connected to the package body (3) by a fixing element (20) and/or the terminal block (6) is connected to the cooler (19) by a further fixing element (21), and/or
- the terminal block (6), the package body (3) and/or the cooler (19) each comprise at least one alignment structure, respectively.

13. System (22) according to claim 12, comprising
- a plurality of power devices (1), wherein
- each of at least some of the power devices (1) comprises a single terminal block (6), and/or
- at least some of the power devices (1) comprise a common terminal block (6).

14. Method for producing a power device (1), comprising:
- providing
- at least one power semiconductor chip arranged on a mounting portion (2),
- a package body (3), for the at least one power semiconductor chip, with at least one recess (4) in the package body (3) for exposing at least one partial region of a connection region (5),
- providing
- a molded block (7) with at least one further recess (8), for forming at least one terminal block (6), and
- arranging the at least one terminal block (6) on the package body (3) such that
- at least one first terminal (9) is arranged in the at least one further recess (8),
- the at least one first terminal (9) is further arranged in the at least one recess (4) of the package body (3),
- the at least one first terminal (9) is connected to the at least one partial region of the connection region (5).

15. Method for producing a power device (1) according to claim 14, wherein
- the at least one first terminal (9) is provided in the molded block (7) before arranging the at least one terminal block (6) on the package body (3), or
- the at least one first terminal (9) is provided in the molded block (7) after arranging the at least one terminal block (6) on the package body (3).
